# EUROPEAN PATENT APPLICATION

(11) **EP 4 712 127 A1**
(43) Date of publication of application: **18.03.2026**
(21) Application number: 24220721.5
(22) Date of filing: 17.12.2024
(51) Int. Cl.: H01J 37/32

(54) **PLASMA PROCESSING DEVICE AND PLASMA PROCESSING METHOD**

(30) Priority: 13.09.2024 JP 2024159397
(71) Applicant: Kioxia Corporation, Tokyo 108-0023 (JP)
(72) Inventor: Tamura, Takahiro, Tokyo, 108-0023 (JP); Ikariyama, Rikyu, Tokyo, 108-0023 (JP)
(74) Representative: Marks & Clerk LLP

(57) **Abstract**

A plasma processing device comprises: a plasma generating chamber which is connected to a raw material supplier and generates a plasma of a raw material supplied from the raw material supplier; a plasma processing chamber which is adjacent to the plasma generating chamber and has a substrate placed therein; and a filter which is disposed between the plasma generating chamber and the plasma processing chamber, and allows a part of particles included in the generated plasma to pass therethrough, wherein the filter comprises: holes ranging over the plasma generating chamber and the plasma processing chamber; and a heater that heats the holes.

## Description

### BACKGROUND

### Field

The present embodiments relate to a plasma processing device and a plasma processing method.

### Description of the Related Art

There is known a plasma processing device comprising: a plasma generating chamber that generates a plasma; and a plasma processing chamber that processes a substrate with the generated plasma.

### BRIEF DESCRIPTION OF THE DRAWINGS

FIG. 1 is a schematic cross-sectional view of a plasma processing device according to a first embodiment;
FIG. 2A is a schematic plan view showing a filter in the case of the filter being viewed from above;
FIG. 2B is a schematic cross-sectional view of the filter;
FIG. 3 is a schematic cross-sectional view showing how particles included in plasma pass through a hole;
FIG. 4A is a schematic plan view showing a filter according to a second embodiment in the case of the filter being viewed from above;
FIG. 4B is a schematic cross-sectional view of the filter;
FIG. 5 is a schematic cross-sectional view of a plasma processing device according to a third embodiment;
FIG. 6 is an explanatory diagram showing a void of a substrate under various conditions; and
FIG. 7 is an explanatory diagram showing a void of a substrate under various conditions.

### DETAILED DESCRIPTION

A plasma processing device according to one embodiment comprises: a plasma generating chamber which is connected to a raw material supplier and generates a plasma of a raw material supplied from the raw material supplier; a plasma processing chamber which is adjacent to the plasma generating chamber and has a substrate placed therein; and a filter which is disposed between the plasma generating chamber and the plasma processing chamber, and allows a part of particles included in the generated plasma to pass therethrough. The filter comprises: holes ranging over the plasma generating chamber and the plasma processing chamber; and a heater that heats the holes.

Next, plasma processing devices according to embodiments will be described in detail with reference to the drawings. Note that the following embodiments are merely examples, and are not shown with the intention of limiting the present invention. Moreover, the following drawings are schematic, and, for convenience of description, a part of configurations, and so on, thereof will sometimes be omitted. Moreover, portions that are common to a plurality of embodiments will be assigned with the same symbols, and descriptions thereof sometimes omitted.

Moreover, in the present specification, when a first configuration is said to be "electrically connected" to a second configuration, the first configuration may be connected to the second configuration directly, or the first configuration may be connected to the second configuration via a wiring, or the like.

Moreover, in the present specification, a certain direction parallel to an upper surface of a stage on which a substrate can be placed will be referred to as an X-direction, a direction parallel to the upper surface of the stage and perpendicular to the X-direction will be referred to as a Y-direction, and a direction perpendicular to the upper surface of the stage will be referred to as a Z-direction.

Moreover, in the present specification, when the likes of a "width", a "length", or a "thickness" in a certain direction is referred to for a configuration, a member, and so on, this will sometimes mean a width, a length, or a thickness, and so on, in a cross section observed by the likes of SEM (Scanning Electron Microscopy), and so on.

### [First Embodiment]

### [Structure]

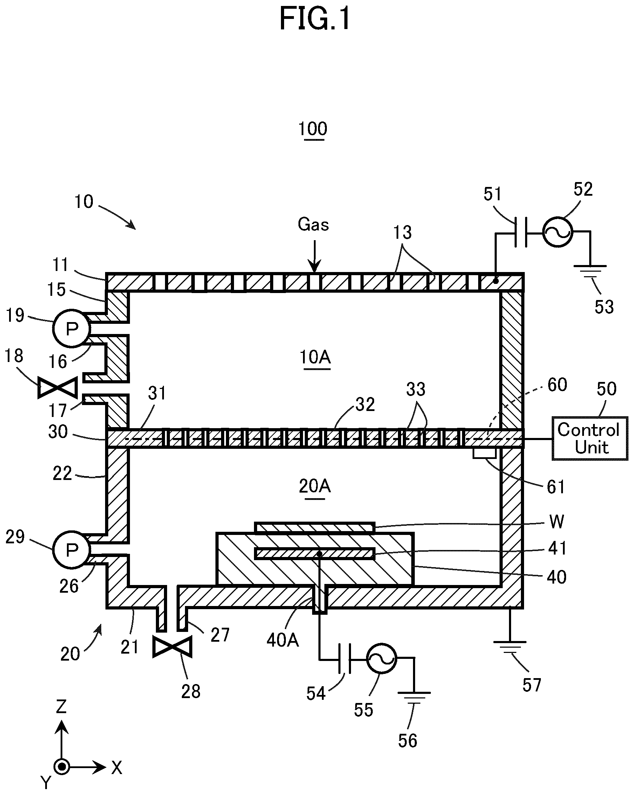

FIG. 1 is a schematic cross-sectional view showing a plasma processing device 100 according to a first embodiment. The plasma processing device 100 is configured as a plasma CVD device (chemical vapor deposition device) that forms a certain layer on a surface of a substrate W by processing the substrate W by a plasma, for example.

The plasma processing device 100 comprises: a plasma generating chamber 10 which generates a plasma of a raw material; a plasma processing chamber 20 which is adjacent to the plasma generating chamber 10 and has the substrate W placed therein; and a filter 30 which is disposed between the plasma generating chamber 10 and the plasma processing chamber 20.

The plasma generating chamber 10 comprises: an upper wall 11 which extends in a planar direction including the X-direction and the Y-direction (hereafter, simply referred to as a planar direction); and a side wall 15 which ranges along an end portion in the planar direction of the upper wall 11, and extends in the Z-direction on a lower side of the upper wall 11. An inner portion 10A of the plasma generating chamber 10, which is a space between the filter 30 and the upper wall 11, acts as a space partitioned by the filter 30, the upper wall 11, and the side wall 15.

The upper wall 11 acts as a raw material supplier (sometimes also referred to as a shower head) that supplies the inner portion 10A of the plasma generating chamber 10 with a gas of a raw material (indicated as Gas in FIG. 1) employed in processing of the substrate W. The plasma generating chamber 10 is connected to the upper wall 11 acting as the raw material supplier. The upper wall 11 comprises a plurality of supply ports 13 which are disposed in a form arranged in the planar direction, and are open in the Z-direction. The upper wall 11 allows the gas of the raw material to pass through the plurality of supply ports 13, and is thereby able to supply the gas of the raw material to the inner portion 10A from outside of the plasma generating chamber 10. The plasma generating chamber 10 turns into a plasma the gas of the raw material that has passed through the supply ports 13 and been supplied to the inner portion 10A, and is thereby able to generate a plasma of the raw material.

The side wall 15 comprises: a communicating portion 16 that ranges over a pressure gauge 19 measuring pressure of the inner portion 10A of the plasma generating chamber 10 (hereafter referred to as internal pressure of the plasma generating chamber 10); and an exhausting portion 17 that discharges a gas, and so on, of the inner portion 10A of the plasma generating chamber 10 to outside. The exhausting portion 17 is connected to a first pressure-adjusting mechanism 18 that adjusts the internal pressure of the plasma generating chamber 10. The side wall 15 may act as an insulator configured by a material such as aluminum oxide, for example. The first pressure-adjusting mechanism 18 acts as a valve that adjusts an exhaust amount of the gas, and so on, discharged from the exhausting portion 17, for example. This valve may act as an APC valve capable of adjusting the exhaust amount in conjunction with the pressure gauge 19, it being configured possible for openness of said valve to be lowered and exhaust amount reduced when the internal pressure of the plasma generating chamber 10 is lower than an arbitrarily specified pressure, and for openness of said valve to be raised and exhaust amount increased when the internal pressure of the plasma generating chamber 10 is higher than an arbitrarily specified pressure. Downstream of the first pressure-adjusting mechanism 18 may be connected with a vacuum pump. Note that a method of adjusting the internal pressure of the plasma generating chamber 10 by the first pressure-adjusting mechanism 18 is not particularly limited. Moreover, the side wall 15 is not limited to being an insulator, and may be made of a metal. In that case, the plasma generating chamber 10 may comprise an insulating portion (a ring, or the like, configured by a material such as aluminum oxide, for example) insulating the upper wall 11 and the side wall 15.

A Capacitively Coupled Plasma system (CCP system) is adopted as a system for generating plasma by the plasma generating chamber 10. The plasma processing device 100 comprises a blocking capacitor 51, a high-frequency power supply 52, and an earth 53 that are electrically connected to the upper wall 11 via a power supply line. In the present embodiment, the upper wall 11 acting as the raw material supplier corresponds to a first electrode.

By power being supplied from the high-frequency power supply 52, and a high-frequency voltage of a certain frequency being applied to the upper wall 11, the plasma generating chamber 10 can turn into a plasma the gas of the raw material supplied to its inner portion 10A, and generate a plasma of the raw material. Note that the system for generating plasma in the plasma generating chamber 10 is not particularly limited, and may be the likes of an Inductively Coupled Plasma discharge system (ICP system) or hollow cathode discharge system, besides the above-described CCP system.

The raw material supplied to the plasma generating chamber 10 is not particularly limited, and a variety of gases (gas species) employed in processing of the substrate W may be appropriately adopted as the raw material. Adoptable as this raw material is, for example, at least one of the likes of a tetraethoxysilane (TEOS) gas employed for forming a silicon oxide film (SiO film) on the substrate W, a silane (SiH₄)-based gas employed for forming a silicon nitride film (SiN film) on the substrate W, and a hydrocarbon (CH₄, C₂H₆, and so on)-based gas employed for forming a carbon film on the substrate W. This raw material may include a carrier gas such as argon or helium.

The plasma processing chamber 20 comprises: a lower wall 21 which extends in the planar direction; and a side wall 22 which ranges along an end portion in the planar direction of the lower wall 21, and extends in the Z-direction on an upper side of the lower wall 21. An inner portion 20A of the plasma processing chamber 20, which is a space between the filter 30 and the lower wall 21, acts as a space partitioned by the filter 30, the lower wall 21, and the side wall 22. The lower wall 21, which is electrically connected to an earth 57, is grounded.

The lower wall 21 comprises a exhausting portion 27 that discharges a gas, and so on, of the inner portion 20A of the plasma processing chamber 20 to outside. The exhausting portion 27 is connected to a second pressure-adjusting mechanism 28 that adjusts pressure of the inner portion 20A of the plasma processing chamber 20 (hereafter referred to as internal pressure of the plasma processing chamber 20). The side wall 22 comprises a communicating portion 26 that ranges over a pressure gauge 29 measuring the internal pressure of the plasma processing chamber 20. The second pressure-adjusting mechanism 28 may act as an APC valve capable of adjusting an exhaust amount in conjunction with the pressure gauge 29, for example, it being configured possible for openness of said valve to be lowered and exhaust amount reduced when the internal pressure of the plasma processing chamber 20 is lower than an arbitrarily specified pressure, and for openness of said valve to be raised and exhaust amount increased when the internal pressure of the plasma processing chamber 20 is higher than an arbitrarily specified pressure. Downstream of the second pressure-adjusting mechanism 28 may be connected with a vacuum pump. Note that a method of adjusting the internal pressure of the plasma processing chamber 20 by the second pressure-adjusting mechanism 28 is not particularly limited.

The plasma processing device 100 drives at least one of the first pressure-adjusting mechanism 18 and the second pressure-adjusting mechanism 28 to adjust pressure so that the plasma processing chamber 20 will be at a lower pressure than the plasma generating chamber 10. When as a result of internal pressure of the plasma generating chamber 10 and internal pressure of the plasma processing chamber 20 having been measured by the pressure gauges 19, 29, internal pressure of the plasma processing chamber 20 is greater than or equal to internal pressure of the plasma generating chamber 10, then, for example, the second pressure-adjusting mechanism 28 may be driven (openness of the valve may be raised and exhaust amount from the exhausting portion 27 thereby increased) to lower the internal pressure of the plasma processing chamber 20. When internal pressure of the plasma processing chamber 20 is less than (is at a lower pressure than) internal pressure of the plasma generating chamber 10, then in order to maintain that state, for example, drive of both the first pressure-adjusting mechanism 18 and the second pressure-adjusting mechanism 28 may be maintained (openness of both valves may be maintained and exhaust amounts from the exhausting portions 17, 27 thereby maintained) to maintain internal pressure of the plasma processing chamber 20 and internal pressure of the plasma generating chamber 10.

When internal pressure of the plasma generating chamber 10 is assumed to be P₁ and internal pressure of the plasma processing chamber 20 is assumed to be P₂, their pressure difference P₁-P₂ is preferably between 3 Pa and 1000 Pa inclusive, more preferably between 30 Pa and 700 Pa inclusive, and even more preferably between 50 Pa and 500 Pa inclusive. When the pressure difference P₁-P₂ is in such a range, then plasma generated by the plasma generating chamber 10 can be suitably moved to the plasma processing chamber 20 via the filter 30. Moreover, a ratio of particles included in the plasma moving to the plasma processing chamber 20 (a ratio of high-sticking particles and low-sticking particles which will be mentioned later) can be set to a suitable range, and step-coverage characteristics of the substrate W can be improved.

The plasma processing chamber 20 comprises: a stage 40 which is configured capable of having the substrate W placed thereon, and which contacts the lower wall 21; and a second electrode 41 which is disposed inside the stage 40. The stage 40 comprises a protrusion 40A that protrudes downwardly penetrating the lower wall 21. The second electrode 41 may have a function of acting as a chuck electrode that electrostatically adsorbs onto the stage 40 the substrate W placed on the stage 40.

A Capacitively Coupled Plasma system (CCP system) is adopted as a system for generating plasma by the plasma processing chamber 20. The plasma processing device 100 comprises a blocking capacitor 54, a high-frequency power supply 55, and an earth 56 that are electrically connected to the second electrode 41 via a power supply line. The power supply line connected to the second electrode 41 passes along the inside of the protrusion 40A to be connected to the blocking capacitor 54. The upper wall 11 acting as the first electrode, and the second electrode 41 configure a pair of parallel plate electrodes.

By power being supplied from the high-frequency power supply 55, and a high-frequency voltage of a certain frequency being applied to the second electrode 41, the plasma processing chamber 20 can turn into a plasma (ionize) again the plasma of the raw material that has moved to the inner portion 20A of the plasma processing chamber 20 via holes 33 of the filter 30 from the inner portion 10A of the plasma generating chamber 10, and accelerate the plasma to a substrate W side. The frequency of the high-frequency voltage applied to the second electrode 41 (application system) is not particularly limited. However, from a viewpoint of suppressing reaction of fellow raw materials or of accelerating ionization of the plasma, an application system where mainly a low frequency (for example, 400 kHz) is superimposed with a high frequency (for example, 13.56 MHz), or a high-frequency pulse system where a high frequency is intermittently applied, is preferable.

The filter 30 comprises: a main body portion 32; and an end portion 31 located in a periphery of the main body portion 32. The filter 30 is attached to the side wall 15 of the plasma generating chamber 10 and the side wall 22 of the plasma processing chamber 20, and contacts them in this form. Note that these two side walls 15, 22 may range along the Z-direction, and that the filter 30 may be attached to at least one of these two side walls 15, 22.

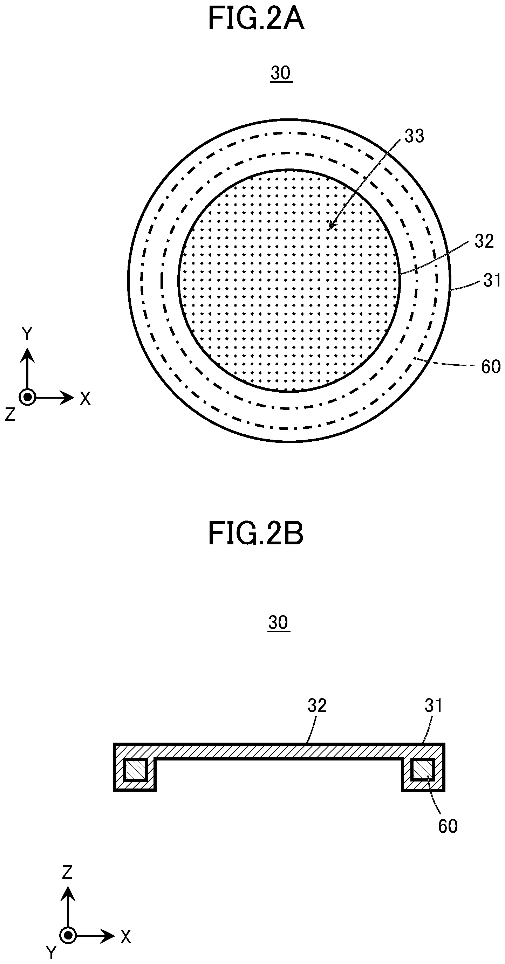

As shown in FIGS. 1, 2A, and 2B, the filter 30 comprises: a plurality of the holes 33 disposed in the main body portion 32, the plurality of holes 33 penetrating in the Z-direction so as to range over the inner portion 10A of the plasma generating chamber 10 and inner portion 20A of the plasma processing chamber 20; and a heater 60 that heats the plurality of holes 33. Meanwhile, as shown in FIG. 1, the plasma processing device 100 comprises: a detector 61 that detects temperature of the holes 33 (more specifically, temperature of a periphery of the holes 33); and a controller 50 that controls a heating temperature that the periphery of the holes 33 is heated by the heater 60 to be 100 degrees or more, based on the temperature of the holes 33 detected by the detector 61.

The heating temperature of the holes 33 by the heater 60 may be appropriately changed. However, from a viewpoint of improving step-coverage characteristics or stabilizing step-coverage characteristics, heating temperature of the holes 33 by the heater 60 is preferably between 100 degrees and 500 degrees inclusive, more preferably between 150 degrees and 470 degrees inclusive, and even more preferably between 250 degrees and 450 degrees inclusive. Although a method by which the controller 50 controls the heater 60 is not particularly limited, the following may be adopted, namely, for example, the controller 50 performing heating by the heater 60 in the case where temperature of the holes 33 detected by the detector 61 has become less than 100 degrees (an arbitrarily determined setting temperature in the above-described range of the heating temperature), and stopping heating by the heater 60 in the case where the temperature of the holes 33 detected by the detector 61 has exceeded 100 degrees (the setting temperature). The detector 61, which is configured as a thermocouple, for example, is disposed in a close vicinity of the filter 30. Note that the detector 61 has been shown at a location in contact with the filter 30 in FIG. 1, but is not limited to this location.

A material of the filter 30 includes not less than 10 atm% with respect to the entire filter 30 of one or two or more kinds selected from the group consisting of aluminum, silicon, yttrium, and carbon. Aluminum is preferable among those, as the material of the filter 30, from a viewpoint of suitably processing the substrate. Moreover, the material of the filter 30 is assumed to have etching resistance with respect to a cleaning gas. Although the cleaning gas is not particularly limited, a fluorine-based gas such as hydrogen fluoride, sulfur hexafluoride, hexafluoroethane, or octafluoropropane, for example, may be cited as the cleaning gas. The cleaning gas is supplied to the plasma generating chamber 10 or plasma processing chamber 20 to be employed when cleaning their inner portions 10A, 20A or the filter 30, after the substrate W has been processed by the plasma, for example.

FIG. 2A is a schematic plan view showing the filter 30 in the case of the filter 30 being viewed from above. FIG. 2B is a schematic cross-sectional view of the filter 30 (with the plurality of holes 33 omitted). As shown in FIGS. 2A and 2B, the main body portion 32 of the filter 30 has a circular shape in planar view. The end portion 31 of the filter 30 is disposed on an outer side in the planar direction of the main body portion 32, and has an annular shape in planar view. The main body portion 32 has a thinner thickness in the Z-direction than does the end portion 31.

In the main body portion 32, the plurality of holes 33 are parallelly disposed along the planar direction. A form in which the plurality of holes 33 are arranged is not particularly limited, and the plurality of holes 33 may be disposed so as to become sparser the further they are to the outer side (may be disposed so that the number of holes 33 per unit area decreases the closer the end portion 31 is approached) in the planar direction of the main body portion 32, or may be disposed so as to become denser the further they are to the outer side (may be disposed so that the number of holes 33 per unit area increases the closer the end portion 31 is approached) in the planar direction of the main body portion 32. The heater 60 is provided inside the end portion 31. The heater 60 is laid in an annularly-shaped form along the end portion 31. When the end portion 31 is heated by the heater 60, heat is transmitted from the end portion 31 to the main body portion 32, and the plurality of holes 33 are heated.

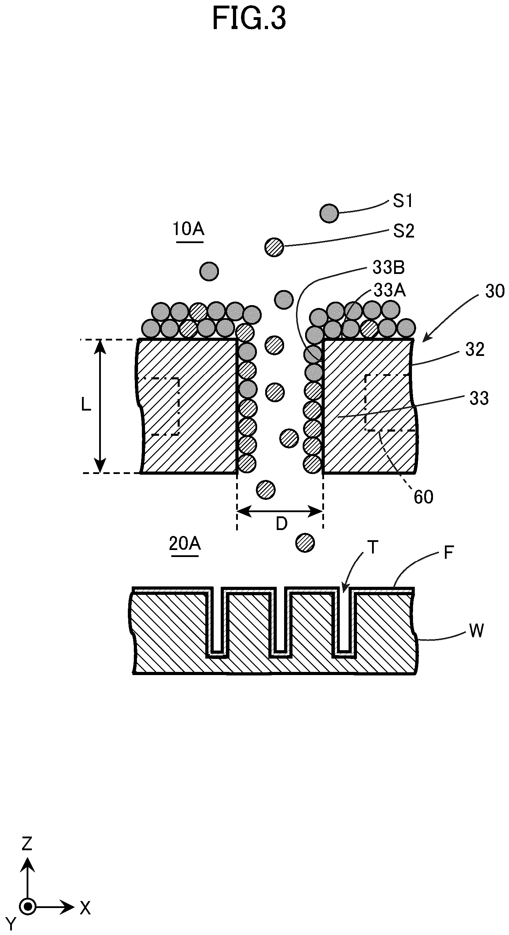

FIG. 3 is a schematic cross-sectional view showing how particles S1, S2 included in plasma pass through the hole 33 (the heater 60 is depicted in a close vicinity of the hole 33 for the sake of convenience). As shown in FIG. 3, in the hole 33, aspect ratio (L/D) which is a value of length (hole depth) L in the Z-direction divided by diameter (hole diameter) D is between 1 and 10 inclusive. The aspect ratio is preferably between 1 and 8 inclusive, more preferably between 1 and 5 inclusive, and even more preferably between 1.5 and 3 inclusive, from a viewpoint of suitably processing the substrate. This aspect ratio may be taken as an average aspect ratio. The average aspect ratio is found by, for example, acquiring an SEM image of a cross section of the filter 30, and for a plurality (for example, 20 or more) of the holes 33 arbitrarily chosen from that image, finding their respective aspect ratios, and calculating an average value of these aspect ratios.

The diameter D of the hole 33 is between 0.5 mm and 2 mm inclusive. The diameter D of the hole 33 is preferably between 0.5 mm and 1.5 mm inclusive, and more preferably between 0.5 mm and 1.0 mm inclusive, from a viewpoint of suitably processing the substrate. This diameter D may be taken as an average diameter. The average diameter is found by, for example, acquiring an SEM image of a cross section of the filter 30, and for a plurality (for example, 20 or more) of the holes 33 arbitrarily chosen from that image, finding their respective diameters, and calculating an average value of these diameters.

The plasma generating chamber 10 generates as plasma at least a first particle S1 and a second particle S2 that sticks to the filter 30 less easily than does the first particle S1 (the generated particles included in plasma include at least the first particle S1 and the second particle S2 that sticks to the filter 30 less easily than does the first particle S1). Ease of sticking (difficulty of sticking) to the filter 30 for each of the particles S1, S2 can be determined by Sticking Coefficients of each of the particles S1, S2. The Sticking Coefficient may change due to various conditions such as peripheral environment of temperature or pressure, and so on, and features of the particles themselves, but, as an example, can be estimated by the number of dangling bonds (dangling bonds in atoms) included in each of the particles S1, S2. For a certain particle, the larger the number of its dangling bonds, the higher its Sticking Coefficient will be, and the easier it will be for it to stick to the filter 30 (this particle will be referred to as a high-sticking particle), and the smaller the number of its dangling bonds, the lower its Sticking Coefficient will be, and the more difficult it will be for it to stick to the filter 30 (this particle will be referred to as a low-sticking particle). The first particle S1, which has a relatively larger number of dangling bonds than the second particle S2, will be regarded as a high-sticking particle. On the other hand, the second particle S2, which has a relatively smaller number of dangling bonds than the first particle S1, will be regarded as a low-sticking particle. Note that the plasma generating chamber 10 may be configured to generate three or more kinds of particles as plasma, besides the above-described two particles S1, S2. The kind of particle generated by the plasma generating chamber 10 is appropriately changeable by a kind of gas of the raw material, for example.

For example, in the case of TEOS being employed as a raw material of the plasma, application of the high-frequency voltage in the plasma processing chamber 20 leads to SiO dissociating from the TEOS, and the SiO oxidizing to generate SiO₂. At this time, the SiO₂ corresponds to the low-sticking particle (the second particle S2) due to the number of its dangling bonds being smaller than that of SiO, and the SiO corresponds to the high-sticking particle (the first particle S1).

The filter 30 allows a part of the particles included in the plasma generated by the plasma generating chamber 10 to pass therethrough. The first particle S1 sticks relatively more to a surface of the main body portion 32 (for example, to an opening portion 33A opening onto an inner portion 10A side of the plasma generating chamber 10, or to a side surface 33B, in the hole 33 of the main body portion 32) of the filter 30 than does the second particle S2, so relatively more particles S2 pass through the hole 33 than do first particles S1. The second particle S2 that has passed through the hole 33 ionizes by being re-applied with a high frequency in the inner portion 20A of the plasma processing chamber 20, and is formed as a film F by being stacked on a surface or trench (trench) T of the substrate W.

The substrate W includes a semiconductor wafer of the likes of a silicon substrate, for example. An application of the substrate W is not particularly limited, and it may be for a semiconductor device or may be for a semiconductor memory component. Application as a semiconductor memory component is not particularly limited, and a three-dimensional NAND type flash memory may be cited as an example.

### [Method]

Next, a plasma processing method will be described. The plasma processing method is performed as part of a step for manufacturing a semiconductor device from the substrate W, for example.

As shown in FIG. 1, the plasma processing method processes the substrate W by a plasma generated using the plasma processing device 100. More specifically, the plasma processing method includes: a generating step of generating a plasma of a raw material supplied from the upper wall 11 acting as the raw material supplier, in the plasma generating chamber 10 connected to the upper wall 11; a passing-through step of passing a part of the particles included in the generated plasma through the holes 33 of the filter 30 disposed between the plasma generating chamber 10 and the plasma processing chamber 20 adjacent to the plasma generating chamber 10; and a processing step of processing the substrate W by the plasma in the plasma processing chamber 20.

In the generating step, a raw material gas is supplied to the inner portion 10A of the plasma generating chamber 10 from the upper wall 11, and power is supplied from the high-frequency power supply 52 to apply a high-frequency voltage of a certain frequency to the upper wall 11 and thereby turn into a plasma the gas of the raw material supplied to the inner portion 10A of the plasma generating chamber 10, and generate a plasma of the raw material.

In the passing-through step, the plasma of the raw material is passed through the plurality of holes 33 whose aspect ratio is between 1 and 10 inclusive, and that have diameters of between 0.5 mm and 2 mm inclusive. Moreover, the passing-through step includes a heating step of heating the plurality of holes 33 by the heater 60.

Furthermore, the passing-through step may include a pressure-adjusting step of driving at least one of the first pressure-adjusting mechanism 18 and the second pressure-adjusting mechanism 28 to adjust pressure so that the plasma processing chamber 20 will be at a lower pressure than the plasma generating chamber 10. Moreover, the passing-through step may include an accelerating step of supplying power from the high-frequency power supply 55 and applying a high-frequency voltage of a certain frequency to the second electrode 41 to turn into a plasma (ionize) again in the plasma processing chamber 20 the plasma of the raw material that has moved to the inner portion 20A of the plasma processing chamber 20 via the holes 33 of the filter 30 from the inner portion 10A of the plasma generating chamber 10, and accelerate the plasma to the substrate W side.

In the processing step, the plasma that has passed through the holes 33 (mainly second particles S2) is stacked on the surface or trench T of the substrate W to form the film F.

### [Advantages]

Conventionally, the likes of ALD (Atomic Layer Deposition), thermal CVD, and plasma CVD have been cited as methods of processing a substrate. However, in processing of a substrate by ALD or thermal CVD, film-forming speed or throughput are comparatively low. Thermal CVD has higher throughput than ALD, but requires the substrate to be set to a high temperature and so cannot be applied to a device with a low resistance to heat. On the other hand, processing of a substrate by plasma CVD has higher film-forming speed compared to ALD or thermal CVD, and allows a film to be formed at low temperature, but its step-coverage characteristics (level-difference covering characteristics) are poor, and it is difficult for it to be used in film formation of a substrate having a high aspect structure, for example.

As shown in FIGS. 1 to 3, the plasma processing device 100 according to the present embodiment comprises: the plasma generating chamber 10 which is connected to the raw material supplier 11 and generates a plasma of a raw material supplied from the raw material supplier 11; the plasma processing chamber 20 which is adjacent to the plasma generating chamber 10 and has the substrate W placed therein; and the filter 30 which is disposed between the plasma generating chamber 10 and the plasma processing chamber 20, and allows a part of particles included in the generated plasma to pass therethrough, the filter 30 comprising the holes 33 ranging over the plasma generating chamber 10 and the plasma processing chamber 20.

Due to such a configuration, the high-sticking particles that stick easily to the filter 30, of the plasma generated by the plasma generating chamber 10 can be sticked to the filter 30, and the low-sticking particles that do not stick easily to the filter 30, of the plasma generated by the plasma generating chamber 10 can be passed through the holes 33 to be moved to the plasma processing chamber 20, and step-coverage characteristics can be improved. Moreover, since configuration of the holes 33 of the filter 30 (their number, hole diameter, depth, and so on) will be appropriately changeable, the ratio of high-sticking particles and low-sticking particles moving to the plasma processing chamber 20 of the plasma (referred to as particle ratio) can be adjusted, thereby enabling adjustment of step-coverage characteristics. Moreover, it becomes possible for occurrence of changes in post-processing characteristics of the substrate W every lot or portion of the substrate surface to be suppressed, and for those characteristics to be maintained (step-coverage characteristics to be stabilized). Furthermore, since processing of the substrate W is performed by a plasma, processing of the substrate W can be performed at a higher speed compared to in a conventional ALD or thermal CVD process, and it becomes possible for productivity to be improved and for the present technology to be applied to wide-ranging film types and gas systems (raw materials). It thus becomes possible to provide a plasma processing device 100 capable of suitably processing the substrate W.

Now, when particles included in plasma stick to the holes of the filter and the holes get clogged, it becomes difficult for the particles to pass through the holes, and performance of the filter drops (this is referred to as hole-clogging). In such a case, there is concern about a lowering of step-coverage characteristics or that post-processing characteristics of the substrate will change every lot or portion of the substrate surface. However, since the filter 30 of the present embodiment comprises the heater 60 to heat the holes 33, a rise in Sticking Coefficient of the plasma particles caused by lowering of temperature of the holes 33 can be suppressed due to heating of the holes 33 by the heater 60, excessive increase in film-forming speed in the holes 33 can be kept down, and hole-clogging can be suppressed. This makes it possible for step-coverage characteristics to be stabilized.

Moreover, in the present embodiment, the hole 33 of the filter 30 has an aspect ratio of between 1 and 10 inclusive. Such a configuration enables step-coverage characteristics to be further improved. Moreover, in the present embodiment, hole diameter D of the hole 33 is between 0.5 mm and 2 mm inclusive. Due to such a configuration, hole-clogging can be suppressed to enable stabilization of step-coverage characteristics in connection with the lower limit value of hole diameter D. Moreover, occurrence of abnormal discharge can be suppressed in connection with the upper limit value of hole diameter D.

Moreover, in the present embodiment, the plasma generating chamber 10 is configured to generate as plasma the first particles S1 and the second particles S2 that stick to the filter 30 less easily than do the first particles S1, and the filter 30 is configured so that, due to it being sticked to by the first particles S1, relatively more of the second particles S2 will pass through the holes 33. Such a configuration makes it possible to provide a practical plasma processing device 100 with improved step-coverage characteristics.

Moreover, in the present embodiment, the plasma processing device 100 comprises the pressure-adjusting mechanisms 18, 28 that adjust pressure so that the plasma processing chamber 20 will be at a lower pressure than the plasma generating chamber 10. Due to such a configuration, flow rate of particles included in plasma passing through the holes 33 of the filter 30 can be increased, so it becomes possible for processing speed (film-forming speed) of the substrate W to be improved. Moreover, since flow rate of particles included in plasma passing through the holes 33 of the filter 30 can be suppressed by the pressure-adjusting mechanisms 18, 28, it becomes possible for step-coverage characteristics to be adjusted, or step-coverage characteristics to be stabilized, and so on.

Now, particles included in plasma that have passed through a filter move in a directionless (random) state, and are conformally (uniformly) formed into a film on the substrate W, hence in a film-forming step to the trench, it is easy for a vacant space (a void) to occur due to side surfaces or an opening portion of the trench being blocked, for example. Moreover, when aspect of the trench gets high, it becomes difficult for the raw material to reach a bottom portion of the trench, and it becomes easy for a void to occur (the same applies to film formation by ALD and thermal CVD, too).

In this respect, in the present embodiment, the plasma generating chamber 10 comprises the first electrode 11 and is configured to generate plasma by application of a high-frequency voltage to the first electrode 11, and the plasma processing chamber 20 comprises the second electrode 41 and is configured to accelerate to the substrate W side plasma that has passed through the holes 33, by application of a high-frequency voltage to the second electrode 41.

Due to such a configuration, the particles included in plasma that have passed through the filter 30 can be given a directionality of heading towards the substrate W side. Therefore, deposition rate close to the bottom portion of the trench can be made faster than deposition rate close to the opening portion (entrance) of the trench, and it becomes possible for a faster build-up to occur in the bottom portion of the trench (it becomes possible for bottom-up growth to be encouraged). This makes it possible to reduce voids occurring in the trench and to improve filling-in characteristics to the trench. Moreover, it becomes possible for filling-in characteristics to be improved even for a trench with a comparatively high aspect. Moreover, giving such a directionality enables step-coverage characteristics to be further improved.

Moreover, in the present embodiment, the plasma processing device 100 comprises: the detector 61 that detects temperature of the holes 33; and the controller 50 that controls the heating temperature by the heater 60 to be 100 degrees or more, based on the temperature of the holes 33 detected by the detector 61. Due to such a configuration, particle ratio can be suitably adjusted, and step-coverage characteristics become suitably adjustable. Moreover, it becomes possible to further stabilize step-coverage characteristics.

Moreover, in the present embodiment, the raw material supplier (upper wall 11) includes the showerhead. Such a configuration makes it possible to provide a practical plasma processing device 100.

Moreover, in the present embodiment, the material of the filter 30 includes not less than 10 atm% of one or two or more kinds selected from the group consisting of aluminum, silicon, yttrium, and carbon, and has etching resistance with respect to a cleaning gas. Such a configuration makes it possible to provide a practical plasma processing device 100.

Moreover, the plasma processing method according to the present embodiment processes the substrate W by the plasma generated using the above-described plasma processing device 100. Such steps make it possible to configure a plasma processing method capable of suitably processing the substrate W while enjoying the above-described kinds of advantages.

### [Second Embodiment]

Configurations of the filter 30 and the heater 60 according to the first embodiment are appropriately adjustable. A filter 230 and a heater 260 whose configurations differ from those of the filter 30 and the heater 60 will be described below as a second embodiment.

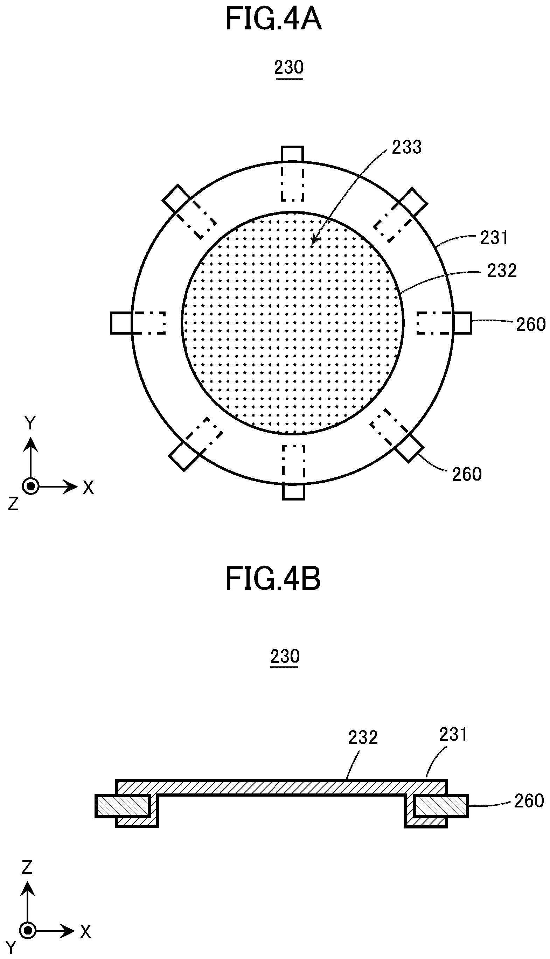

FIG. 4A is a schematic plan view of the filter 230 in the case of being viewed from above. FIG. 4B is a schematic cross-sectional view of the filter 230 (with a plurality of holes 233 omitted). As shown in FIGS. 4A and 4B, in the filter 230, an end portion 231 of annular shape disposed further to an outer side in the planar direction than a main body portion 232, is provided with a plurality of the heaters 260. The plurality of heaters 260 are disposed at certain intervals from each other in a form along a peripheral direction of the end portion 231. The heater 260 has a bar shape extending radially from a center toward an outer side in the planar direction of the filter 230. One portion of the heater 260 is accommodated inside the end portion 231, and the other portion of the heater 260 protrudes to outside of the end portion 231.

Due to such a configuration, the plurality of holes 233 disposed in the main body portion 232 can be suitably heated by the heater 260, and occurrence of heating variations can be suppressed in the main body portion 232.

### [Third Embodiment]

Configurations of the plasma generating chamber 10 and the plasma processing chamber 20 according to the first embodiment are appropriately adjustable. A plasma generating chamber 310 and a plasma processing chamber 320 whose configurations differ from those of the plasma generating chamber 10 and the plasma processing chamber 20 will be described below as a third embodiment.

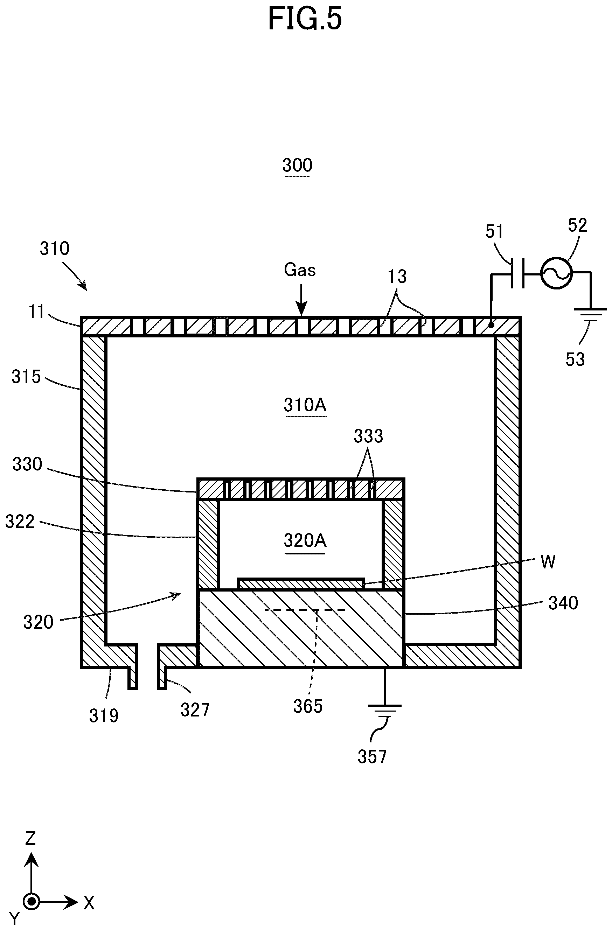

FIG. 5 is a schematic cross-sectional view of a plasma processing device 300 according to the third embodiment. As shown in FIG. 5, the plasma processing device 300 comprises: the plasma generating chamber 310 which generates a plasma of a raw material; the plasma processing chamber 320 which is adjacent to the plasma generating chamber 310 in a form of being included in an inner portion 310A of the plasma generating chamber 310, and has the substrate W placed therein; and a filter 330 which is disposed between the plasma generating chamber 310 and the plasma processing chamber 320.

The plasma generating chamber 310 comprises: the upper wall 11; a side wall 315 which ranges along an end portion in the planar direction of the upper wall 11, and extends in the Z-direction on a lower side of the upper wall 11; and a lower wall 319 which ranges along a lower end portion of the side wall 315, and extends in the planar direction. The inner portion 310A of the plasma generating chamber 310, which is a space between the plasma generating chamber 310 and the plasma processing chamber 320, acts as a space partitioned by the filter 330, the upper wall 11, the side wall 315, the lower wall 319, and a side wall 322 of the plasma processing chamber 320.

The side wall 315 has a longer length in the Z-direction than does the side wall 322 of the plasma processing chamber 320. The lower wall 319 comprises a exhausting portion 327 that discharges a gas, and so on, of the inner portion 310A of the plasma generating chamber 310 to outside. The side wall 315 and the lower wall 319 take the form of insulators configured by a material such as aluminum oxide, for example. A Capacitively Coupled Plasma system (CCP system) is adopted as a system for generating plasma by the plasma generating chamber 310.

The plasma processing chamber 320 comprises the side wall 322 which extends in the Z-direction on an upper side of a stage 340. An inner portion 320A of the plasma processing chamber 320, which is a space between the filter 330 and the stage 340, acts as a space partitioned by the filter 330, the stage 340, and the side wall 322.

The stage 340, which is electrically connected to an earth 357, is grounded. The stage 340 comprises a substrate heater 365 that heats the substrate W. A temperature at which the substrate W is heated by the substrate heater 365 is not particularly limited, but from a viewpoint of improving filling-in characteristics or step-coverage characteristics, is preferably 100 degrees or more, more preferably 200 degrees or more, and even more preferably 250 degrees or more.

The filter 330 comprises a plurality of holes 333 penetrating in the Z-direction so as to range over the inner portion 310A of the plasma generating chamber 310 and inner portion 320A of the plasma processing chamber 320. The filter 330 may comprise a heater to heat the plurality of holes 333.

Due to such a configuration, a plasma of the raw material generated by the plasma generating chamber 310 passes through the holes 333 of the filter 330 by diffusion, and is formed as a film on a surface of the substrate W.

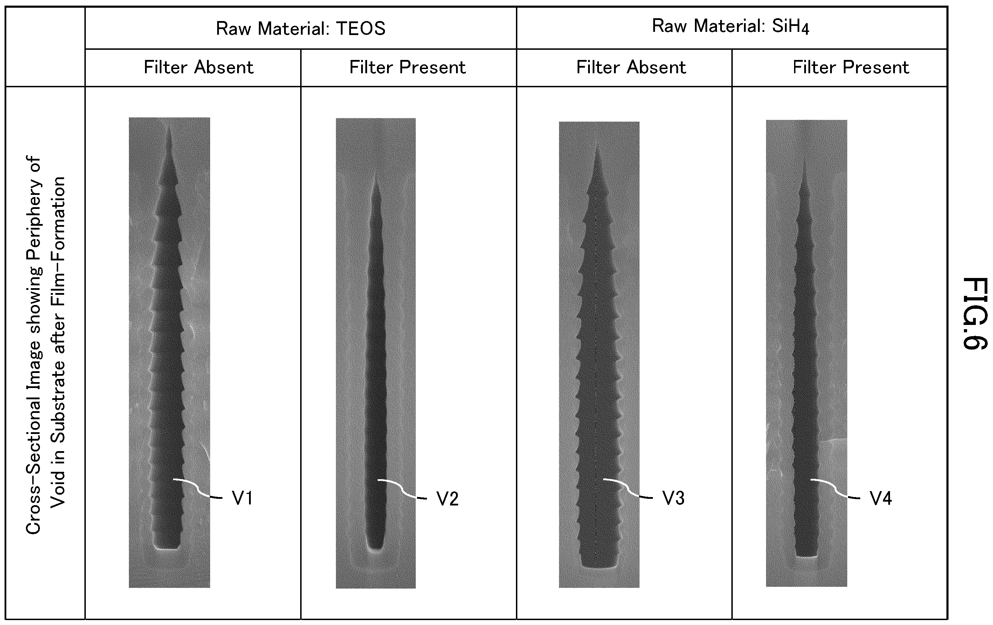

FIG. 6 shows SEM images showing changes in the void occurring in the trench T (refer to FIG. 3) when film-forming processing by plasma is performed on the substrate W under various conditions. The various conditions include whether TEOS or SiH₄ is employed as the raw material of the plasma, and whether there is a configuration where the filter 330 is not attached (described as "filter absent") or a configuration where the filter 330 is attached as in the present embodiment (described as "filter present"). In all cases, internal pressure of the inner portion 310A of the plasma generating chamber 310 is 100 Pa. Moreover, hole diameter of the hole 333 is 0.5 mm, and its aspect ratio is 2.

As shown in FIG. 6, there is clearly a tendency for a void V2 under conditions of TEOS being employed as the raw material of the plasma and filter present to be smaller than a void V1 under conditions of TEOS being employed as the raw material of the plasma and filter absent, specifically, there is clearly a tendency for length in a left-right direction in a plane of paper (corresponding to the X-direction) and length in an up-down direction in a plane of paper (corresponding to the Z-direction) to both be smaller for the void V2 than for the void V1. Moreover, there is clearly a tendency for a void V4 under conditions of SiH₄ being employed as the raw material of the plasma and filter present to be smaller than a void V3 under conditions of SiH₄ being employed as the raw material of the plasma and filter absent, specifically, there is clearly a tendency for length in a left-right direction in a plane of paper and length in an up-down direction in a plane of paper to both be smaller for the void V4 than for the void V3. Thus, in the plasma processing device 300 comprising the filter 330, it is possible for step-coverage characteristics or filling-in characteristics of the substrate W to be improved.

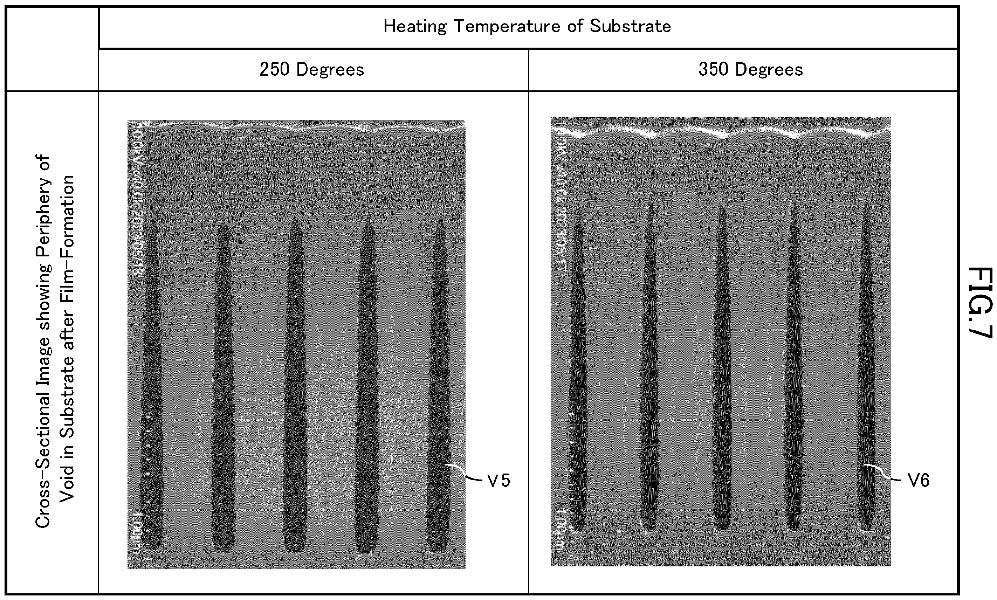

Moreover, the stage 340 comprises the substrate heater 365 that heats the substrate W. Now, FIG. 7 shows SEM images showing changes in the void occurring in the trench T (refer to FIG. 3) when film-forming processing by plasma is performed on the substrate W under various conditions. The various conditions include whether the substrate W is heated at 250 degrees by the substrate heater 365 or is heated at 350 degrees by the substrate heater 365 in a configuration where TEOS is employed as the raw material of the plasma and the filter 330 has been attached as in the present embodiment. In all cases, internal pressure of the inner portion 310A of the plasma generating chamber 310 is 100 Pa. Moreover, hole diameter of the hole 333 is 0.5 mm, and its aspect ratio is 2.

As shown in FIG. 7, there is clearly a tendency that when the temperature at which the substrate W is heated by the substrate heater 365 is raised from 250 degrees to 350 degrees, a void V6 under conditions of the heating temperature being 350 degrees will be smaller than a void V5 under conditions of the heating temperature being 250 degrees, specifically, there is clearly a tendency that when the temperature at which the substrate W is heated by the substrate heater 365 is raised from 250 degrees to 350 degrees, length in a left-right direction in a plane of paper (corresponding to the X-direction) and length in an up-down direction in a plane of paper (corresponding to the Z-direction) will both be smaller for the void V6 than for the void V5. Thus, in the plasma processing device 300 comprising the substrate heater 365 that heats the substrate W, it is possible for step-coverage characteristics or filling-in characteristics of the substrate W to be improved.

### [Other Embodiments]

That concludes description of the plasma processing devices according to the first through third embodiments. However, these configurations are merely exemplifications, and specific configurations may be appropriately adjusted.

For example, in the above-described embodiments, the upper wall of the plasma generating chamber is the raw material supplier and is the first electrode. However, the raw material supplier may be disposed in the side wall of the plasma generating chamber, or there may be disposed in the upper wall of the plasma generating chamber a first electrode acting as a different member from the raw material supplier.

Moreover, for example, in the above-described first embodiment, there has been shown a configuration where the upper wall acting as the first electrode is electrically connected with a high-frequency power supply and earth, and the second electrode is electrically connected with a high-frequency power supply and earth. However, a member connected with the high-frequency power supply and earth is appropriately changeable. The plasma processing device need only have at least a configuration where a high-frequency power supply and earth are connected to a specific member to enable plasma to be generated from a raw material in the plasma generating chamber.

Moreover, a state of the particles included in plasma at a time of passing through the holes of the filter is not particularly limited. For example, one or more types of the likes of ion type particles, radical type particles, and neutral type particles may be cited as the particles included in plasma at a time of passing through the holes of the filter.

### [Others]

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A plasma processing device comprising:
a plasma generating chamber (10) which is connected to a raw material supplier (11) and generates a plasma of a raw material supplied from the raw material supplier;
a plasma processing chamber (20) which is adjacent to the plasma generating chamber and has a substrate (W) placed therein; and
a filter (30) which is disposed between the plasma generating chamber and the plasma processing chamber, and allows a part of particles included in the generated plasma to pass therethrough, wherein
the filter comprises:
holes (33) ranging over the plasma generating chamber and the plasma processing chamber; and
a heater (60) that heats the holes.

2. The plasma processing device according to claim 1, wherein
the holes have an aspect ratio of between 1 and 10 inclusive, and have a diameter of between 0.5 mm and 2 mm inclusive.

3. The plasma processing device according to claim 1 or 2, wherein
the particles include at least a first particle (S1) and a second particle (S2) that sticks to the filter less easily than does the first particle,
the plasma generating chamber is configured to generate at least the first particle and the second particle as the plasma, and
the filter is configured so that, due to it being sticked to by the first particles, relatively more of the second particles will pass through the holes.

4. The plasma processing device according to any one of claims 1 to 3, comprising a pressure-adjusting mechanism (18, 28) that adjusts pressure so that the plasma processing chamber will be at a lower pressure than the plasma generating chamber.

5. The plasma processing device according to any one of claim 1 to 4, wherein
the plasma generating chamber comprises a first electrode (11), and is configured to generate the plasma by application of a high-frequency voltage to the first electrode, and
the plasma processing chamber comprises a second electrode (41), and is configured to accelerate to a substrate side the plasma that has passed through the holes, by application of a high-frequency voltage to the second electrode.

6. The plasma processing device according to any one of claims 1 to 5, comprising:
a heater (60) that heats the holes;
a detector (61) that detects temperature of the holes; and
a controller (50) that controls a heating temperature by the heater to be 100 degrees or more, based on the temperature of the holes detected by the detector.

7. The plasma processing device according to any one of claims 1 to 6, wherein
the raw material supplier includes a shower head (11).

8. The plasma processing device according to any one of claims 1 to 7, wherein
a material of the filter includes not less than 10 atm% of one or two or more kinds selected from the group consisting of aluminum, silicon, yttrium, and carbon, and has etching resistance with respect to a cleaning gas.

9. The plasma processing device according to any one of claims 1 to 8, wherein
the raw material supplier comprises a plurality of supply ports (13) that supply the raw material to an inner portion (10A) of the plasma generating chamber, and
the filter comprises a plurality of the holes disposed at a position facing the plurality of supply ports.

10. The plasma processing device according to any one of claims 1 to 9, comprising
a heater (60) that heats the holes, wherein
the filter comprises: a main body portion (32); and an end portion (31) located in a periphery of the main body portion, and
the heater is annularly shaped along the end portion.

11. The plasma processing device according to any one of claims 1 to 9, comprising
a heater (260) that heats the holes (233), wherein
the filter (230) comprises: a main body portion (232); and an end portion (231) located in a periphery of the main body portion,
a plurality of the heaters are provided along the end portion, and
the plurality of heaters extend radially in a planar direction of the filter.

12. The plasma processing device according to claim 4, wherein
the pressure-adjusting mechanism includes:
a first pressure-adjusting mechanism (18) connected to the plasma generating chamber; and
a second pressure-adjusting mechanism (28) connected to the plasma processing chamber, and
the pressure-adjusting mechanism drives at least one of the first pressure-adjusting mechanism and the second pressure-adjusting mechanism to adjust pressure so that the plasma processing chamber will be at a lower pressure than the plasma generating chamber.

13. The plasma processing device according to claim 5, comprising an earth (53, 56) which is electrically connected to each of the first electrode and the second electrode, wherein
the first electrode and the second electrode configure a pair of parallel plate electrodes between which the filter is disposed.

14. A plasma processing method including:
a generating step of generating a plasma of a raw material supplied from a raw material supplier (11), in a plasma generating chamber (10) connected to the raw material supplier;
a passing-through step of passing a part of the particles included in the generated plasma through holes (33) of a filter (30) disposed between the plasma generating chamber and a plasma processing chamber (20) adjacent to the plasma generating chamber; and
a processing step of processing a substrate (W) by the plasma in the plasma processing chamber, wherein
in the passing-through step, the holes is heated.

15. A plasma processing method including:
a generating step of generating a plasma of a raw material supplied from a raw material supplier (11), in a plasma generating chamber (10) connected to the raw material supplier;
a passing-through step of passing a part of the particles included in the generated plasma through holes (33) of a filter (30) disposed between the plasma generating chamber and a plasma processing chamber (20) adjacent to the plasma generating chamber; and
a processing step of processing a substrate (W) by the plasma in the plasma processing chamber, wherein
in the passing-through step, the plasma is passed through holes that have an aspect ratio of between 1 and 10 inclusive, and have a diameter of between 0.5 mm and 2 mm inclusive.
